# EUROPEAN PATENT APPLICATION

(11) **EP 4 109 516 A2**
(43) Date of publication of application: **28.12.2022**
(21) Application number: 22171283.9
(22) Date of filing: 03.05.2022
(51) Int. Cl.: H01L 21/98, H01L 25/065, H01L 21/60

(54) **STUBS FOR IMPROVING DIE SIZE AND ORIENTATION DIFFERENTIATION IN HYBRID BONDING SELF ASSEMBLY**

(30) Priority: 24.06.2021 US 202117357729
(71) Applicant: INTEL Corporation, Santa Clara, CA 95054 (US)
(72) Inventor: Eid, Feras, Chandler, 85226 (US); Swan, Johanna M., Scottsdale, 85225 (US); Liff, Shawna M., Scottsdale, 85255 (US); Elsherbini, Adel A., Chandler, 85226 (US); Aleksov, Aleksandar, Chandler, 85286 (US)
(74) Representative: Goddar, Heinz J.

(57) **Abstract**

A multi-die module comprises: a first die (705) comprising a first pedestal (307, 407, 507, 707), a plateau (308, 408, 508) around the first pedestal (307, 407, 507, 707), and a stub (330, 430, 530, 630, 730) extending up from the plateau (308, 408, 508); and a second die (420, 520, 720) comprising a second pedestal (422, 522, 722), where the second pedestal (422, 522, 722) is attached to the first pedestal (307, 407, 507, 707). The stub (330) may be a continuous ring that extends around the first pedestal (307), wherein an inner diameter of the continuous ring may be larger than a width of the second pedestal. Alternatively, a plurality of stubs (330) may be provided on the plateau (308, 408, 508), wherein the stubs (330) may be post-like structures or may be elongated. The multi-die module may further comprise a second stub (530₁) on a surface of the first die between the first pedestal (507) and the plateau (508), wherein the second pedestal (522) has a chamfered corner (575) that is adjacent to the second stub (530₁), wherein a maximum width of the second pedestal (522) may be greater than a distance between the stub (530₂) and the second stub (530₁), wherein the die (520) that is placed onto the first pedestal (507) has a matching chamfer so that the die (520) can only fit through the stubs (530) when having a matching rotational orientation of its chamfered surface with the chamfered surface (575) of the first pedestal (507). Orientation differentiation is thus provided by the use of mechanical features (530). The stub (630) may have a top surface (631) that is domed, flat, v-grooved, u-grooved, or pointed. A hydrophilic layer (311, 411, 511, 426, 526) may be present on the first pedestal (307, 407, 507, 707) and on the second pedestal (422, 522, 722). A hydrophobic layer (309, 409, 509) may be present on sidewalls of the first pedestal (307, 407, 507, 707), on a surface of the first die (705) between the first pedestal (307, 407, 507, 707) and the plateau (308, 408, 708), and on the plateau (308, 408, 708).

A method of attaching dies (420_{A}, 420_{B}) to a wafer (405) comprises: attaching a first die (420_{A}) to a first pedestal (407_{A}) on the wafer (405), wherein the first pedestal (407_{A}) is surrounded by one or more first stubs (430_{A}), and wherein the first pedestal (407_{A}) has a first width; and attaching a second die (420_{B}) to a second pedestal (407_{B}) on the wafer (405), wherein the second pedestal (407_{B}) is surrounded by one or more second stubs (430_{B}), and wherein the second pedestal (407_{B}) has a second width that is smaller than the first width of the first pedestal (407_{A}). The second stubs (430_{B}) prevent larger dies (420_{A}) from bonding to smaller pedestal locations (407_{B}) on the wafer (405). In order to prevent smaller dies (420_{B}) from inadvertently attaching to larger pedestals (407_{A}) on the wafer (405), the method may start with the attachment of the largest dies (420_{A}) and then move to progressively smaller dies (420_{B}), ensuring that the larger bonding locations are already occupied before smaller dies (420_{B}) are introduced. Therefore, size differentiation is provided by the use of mechanical features (430) on the wafer (405). The first die (420_{A}) may be attached to the first pedestal (407_{A}) by hydrophilic bonding and the second die (420_{B}) may be attached to the second pedestal (407_{B}) by hydrophilic bonding in a self-assembly process, wherein a liquid (315, 415) (e.g., water) may be disposed on the hydrophilic layer (311, 411, 511) before the die (420_{A}, 420_{B}, 520) is brought into close proximity with the wafer (305, 405, 505), and the liquid (315, 415) exerts an adhesive force that brings the die (420_{A}, 420_{B}, 520) into proper alignment with the wafer (305, 405, 505). The liquid (315, 415) may then be removed (e.g., evaporated) and a bonding process such as a hybrid bonding process may permanently secure the die (420_{A}, 420_{B}, 520) to the wafer (305, 405, 505).

## Description

### TECHNICAL FIELD

Embodiments of the present disclosure relate to electronic packages, and more particularly to alignment features for improving hybrid bonding self-assembly.

### BACKGROUND

Self-assembly is one proposal to enable high throughput die-to-wafer assembly. In a self-assembly architecture, hydrophilic layers are provided over the bonding surfaces of the die and the wafer. Water is applied to one of the hydrophilic layers. The die is then brought into close proximity with the wafer, and the water exerts an adhesive force that attaches the die to the wafer. The water may then be evaporated and hybrid bonding more permanently secures the die to the wafer.

Although the above method improves the throughput compared to a purely pick and place process, it does have limitations. One limitation is that pick and place is still needed for the original pre-alignment stage to bring the die close enough to the wafer to be attracted by the water. As such, throughput is lowered. If a batch process is used instead of the initial pick and place, and the coarse alignment is tolerable, there is still a risk that there will not be significant enough differentiation between dies to be placed at nearby locations. For example, both a first die with a first dimension and a second die with a second, larger, dimension will experience the same bonding force due to the droplet's surface tension when landing on a first wafer location intended for the first die. This may result in the larger second die bonding inadvertently to the wrong location if it reaches the first wafer location before reaching a desired location. Additionally, for a die that has substantially similar x and y dimensions, the above approach will also not necessarily result in the die being bonded in the correct orientation. This is because any 90 degree rotations (in plane) if square, or 180 degree rotations (in plane) if rectilinear will still produce the same bonding force between the die and the wafer.

### BRIEF DESCRIPTION OF THE DRAWINGS

Figure 1A is a cross-sectional illustration of a die being brought to a bonding location on a wafer.
Figure 1B is a cross-sectional illustration of the die bonding to the wafer through attractive forces supplied by a water droplet on the wafer.
Figure 1C is a cross-sectional illustration after the die is aligned through the attractive forces supplied by the water droplet on the wafer.
Figure 1D is a cross-sectional illustration of the die and wafer after the water is evaporated.
Figure 2A is a cross-sectional illustration of a die bonded to the correct location on a wafer.
Figure 2B is a cross-sectional illustration of a die bonded to an incorrect location on a wafer.
Figure 3A is a cross-sectional illustration of a wafer with a pedestal and stubs around the pedestal to prevent inadvertent bonding, in accordance with an embodiment.
Figure 3B is a plan view illustration of the wafer in Figure 3A with a plurality of discrete stubs around a perimeter of the pedestal, in accordance with an embodiment.
Figure 3C is a plan view illustration of the wafer in Figure 3A with a plurality of elongated stubs around a perimeter of the pedestal, in accordance with an embodiment.
Figure 3D is a plan view illustration of the wafer in Figure 3A with a stub ring around a perimeter of the pedestal, in accordance with an embodiment.
Figure 4A is a cross-sectional illustration of a wafer with a first bonding location with a first width and a second bonding location with a second width that is smaller than the first width, in accordance with an embodiment.
Figure 4B is a cross-sectional illustration of the wafer after a first die is bonded to the first bonding location, in accordance with an embodiment.
Figure 4C is a cross-sectional illustration of the wafer after a second die is bonded to the second bonding location, in accordance with an embodiment.
Figure 5A is a plan view illustration of a wafer that includes a pedestal with a chamfered corner and stubs configured to ensure proper rotation of a die that is bonded to the wafer, in accordance with an embodiment.
Figure 5B is a cross-sectional illustration of a die that is properly oriented to interface and bond with the pedestal in Figure 5A, in accordance with an embodiment.
Figure 5C is a cross-sectional illustration of a die that is improperly oriented to interface and bond with the pedestal in Figure 5A, in accordance with an embodiment.
Figure 6A is a cross-sectional illustration of a stub with a flat surface, in accordance with an embodiment.
Figure 6B is a cross-sectional illustration of a stub with a domed surface, in accordance with an embodiment.
Figure 6C is a cross-sectional illustration of a stub with a pointed surface, in accordance with an embodiment.
Figure 6D is a cross-sectional illustration of a stub with a pointed surface, in accordance with an additional embodiment.
Figure 7 is a cross-sectional illustration of an electronic system with a multi-die module with alignment stubs, in accordance with an embodiment.
Figure 8 is a schematic of a computing device built in accordance with an embodiment.

### EMBODIMENTS OF THE PRESENT DISCLOSURE

Described herein are alignment features for improving hybrid bonding self-assembly, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, self-assembly processes for die-to-wafer assembly are promising, but have several significant drawbacks. When a true pick and place process is used to accurately place the dies on the wafer the throughput is reduced. Additionally, in batch processing environments, the strong attractive force of the water can result in misplacing dies, since they may bond to the wrong location or bond to the correct location with a wrong rotational orientation.

Accordingly, embodiments disclosed herein include self-assembly processes that are aided by mechanical stubs (e.g., kinematic or quasi-kinematic features) that enhances die size and orientation differentiation during batch process self-assembly. These stubs prevent improperly sized or oriented dies from bonding at unintended locations on the wafer by mechanically impeding the dies from getting close enough to the wafer surface for the attractive force created by the liquid from becoming significant. As a result, dies do not adhere improperly even if they laterally pass by an unintended bonding location on the wafer. Only properly sized and oriented dies will pass by the stubs and get close enough to the wafer surface for the desired assembly to take place.

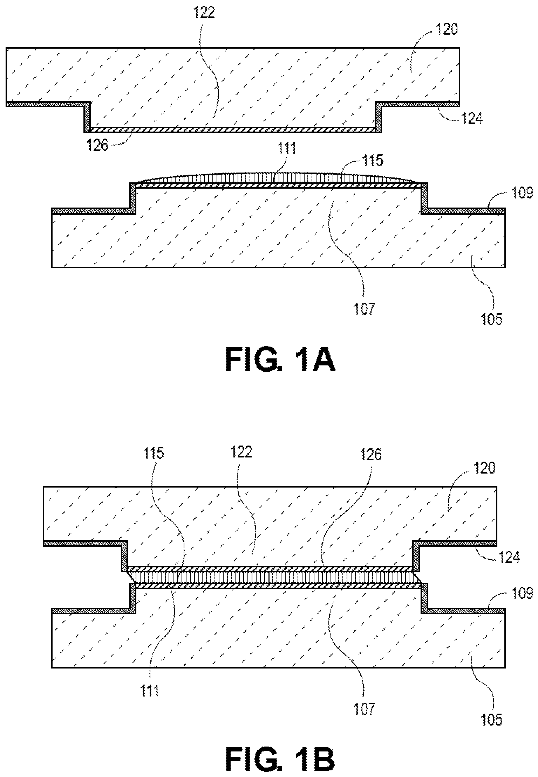

To provide improved context, Figures 1A-1D illustrate a process for self-assembly of a die to a wafer. As shown in Figure 1A, the wafer 105 may comprise a first pedestal 107. A top surface of the pedestal 107 may be covered by a hydrophilic layer 111. The other surfaces of the wafer 105 maybe covered by a hydrophobic layer 109. A drop of liquid 115 (e.g., water) may be applied to the hydrophilic layer 111. The liquid 115 spreads across the hydrophilic layer 111 and is confined by the neighboring hydrophobic layers 109.

The wafer 105 may be a silicon wafer or any other semiconductor substrate. In an embodiment, active circuitry (e.g., transistors, etc.), interconnects, and the like maybe provided in pedestal 107. Active circuitry and interconnects may also be located outside of the pedestal in some implementations. Bonding pads (not shown) may be provided on the top surface of the pedestal 107. The bonding pads may be suitable pads for bonding with a die 120.

The die 120 may be a discrete die that has already been singulated from a wafer. The die 120 may be a different type of die than is provided on the wafer 105. For example, the die 120 may be a memory die and the active circuitry on the wafer may be for a processor, a system on a chip (SoC), a graphics processor, or any other type of die. The die 120 may comprise a pedestal 122. The pedestal 122 maybe covered by a hydrophilic layer 126. The remaining portions of the die 120 may be covered by a hydrophobic layer 124. Bonding pads (not shown) may be provided on the pedestal 122

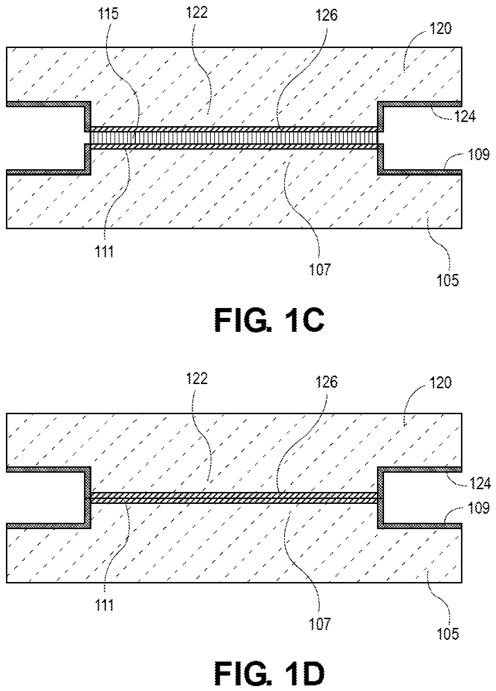

As shown in Figure 1B, the die 120 is brought close to the surface of the pedestal 107 on the wafer 105. An attractive force is exerted between the hydrophilic layer 126 and the fluid 115. Some misalignment (i.e., the die 120 is partially off to the left of the pedestal 107) can be corrected by the fluid 115. As shown in Figure 1C, the attractive force brings the die 120 into proper alignment with the underlying wafer 105 (e.g., to a sub-micron accuracy).

After alignment, the fluid 115 is evaporated, as shown in Figure 1D. A subsequent bonding process (e.g., a hybrid bonding process) maybe implemented to permanently bond the die 120 to the wafer 105. After bonding all of the dies to the wafer 105, the wafer maybe singulated to provide multi-die modules.

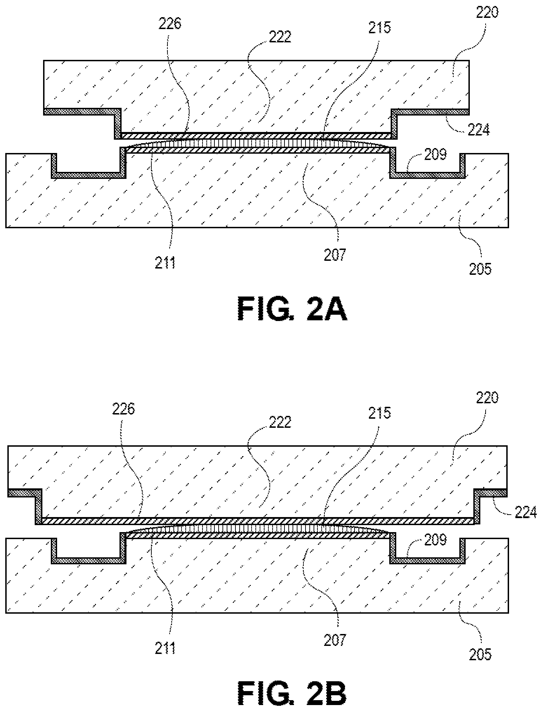

The process described above with respect to Figures 1A-1D is a process that relies on the picking and placing of the individual dies 120 onto the wafer. However, a batch process would be desirable in order to increase throughput. However, when using a batch process, misplacements and improper rotations are a significant problem. Issues with existing batch processing methods are illustrated in Figure 2A and Figure 2B.

In Figure 2A, a cross-sectional illustration of a die 220 on a wafer 205 is shown. The die 220 comprises a pedestal 222 with a hydrophilic layer 226 over the surface of the pedestal 222 and hydrophobic layers 224 over sidewalls of the pedestal 222 and the remainder of the die 220. The wafer 205 comprises a pedestal 207 with a hydrophilic layer 211 over the pedestal 207. A liquid 215 is provided between the two hydrophilic layers 226 and 211. A hydrophobic layer 209 is provided over the remainder of the wafer 205.

As shown, the pedestal 222 of the die 220 is properly aligned with the underlying pedestal 207 on the wafer 205. That is, the size of the die 220 is proper for the specific location on the wafer 205 that is illustrated. However, in some embodiments, a rotation of the die 220 may be incorrect, even when the die size is correctly matched to the pedestal 207 of the wafer 205.

As shown in Figure 2B, the die 220 is too large for the underlying pedestal 207 of the wafer 205. The strong attractive force of the liquid 215 on the hydrophilic layer 226 is sufficient to pull in the die 220, even though the pedestal 207 is too small for the pedestal 222. That is, the die 220 has no way to differentiate between wafer locations based on size. Accordingly, when the die 220 passes over an incorrect location on the wafer 205, the die 220 may be improperly bonded.

As such, embodiments disclosed herein include mechanical features (e.g., stubs) that ensure proper alignment and orientation of the dies to the wafer. The stubs prevent larger dies from bonding to smaller pedestal locations on the wafer. However, the presence of mechanical stops may not prevent smaller dies from inadvertently attaching to larger pedestals on the wafer. Accordingly, processes disclosed herein include an order of operations that prevents small dies from attaching to large pedestals on the wafer. This is done by starting with the attachment of the largest dies and then moving to progressively smaller dies. This order of operations ensures that the larger bonding locations are already occupied before smaller dies are introduced. Therefore, size differentiation is provided by the use of mechanical features on the wafer.

Mechanical features may also be used to ensure proper orientation (i.e., in plane rotational orientation) of the dies to the wafer. This may be done by providing chamfers or other cutouts on the pedestals of the wafer and the die. A mechanical stop is then placed adjacent to the cutout. The mechanical stop by the cutout prevents the die from being brought close enough to the wafer pedestal to bond unless the die is oriented so that its cutout is aligned with the cutout on the wafer. As such, orientation differentiation is provided by the use of mechanical features on the wafer.

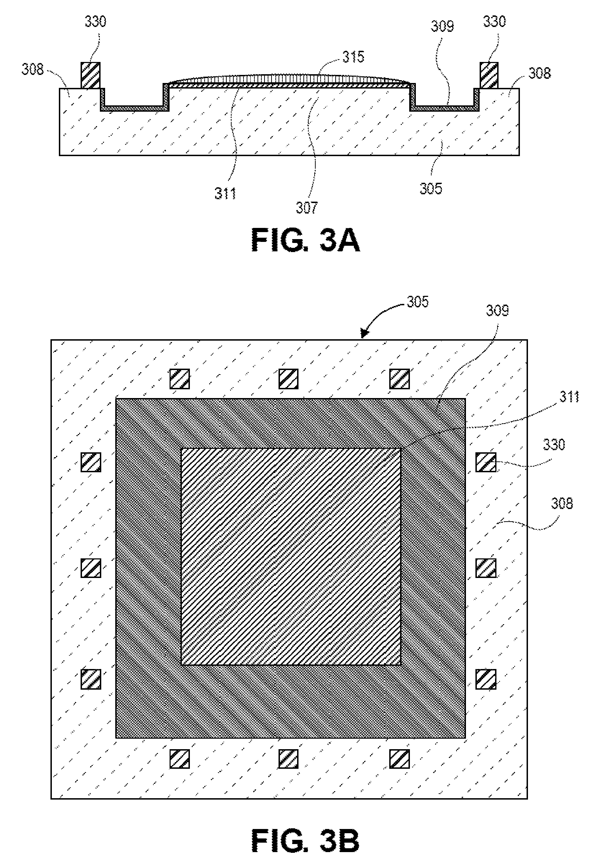

Referring now to Figure 3A, a cross-sectional illustration of a portion of a wafer 305 is shown, in accordance with an embodiment. In an embodiment, the wafer 305 may be a silicon wafer or other semiconductor wafer. A single die location on the wafer 305 is shown in Figure 3A. That is, the structure in Figure 3A may ultimately be singulated from the rest of the wafer 305 after the bonding of an additional die (not shown) to the wafer 305 to form a multi-die module. In an embodiment, the active circuitry (e.g., transistors, interconnects, etc.) of the die may be provided in a pedestal 307 on the wafer 305. In other embodiments, some of the active circuitry may be outside of the pedestal 307.

In an embodiment, the wafer 305 may comprise a hydrophilic layer 311 over the pedestal 307. Particularly, the hydrophilic layer 311 may be provided over a top surface of the pedestal 307. A fluid 315 may be disposed on the hydrophilic layer 311. For example, the fluid 315 may comprise water or any other fluid that has a similarly strong attraction to the hydrophilic layer 311. In an embodiment, a hydrophobic layer 309 may be provided along sidewalls of the pedestal 307, and over remaining portions of the wafer 305. The hydrophobic layer 309 borders the perimeter of the hydrophilic layer 311, and the hydrophobic layer 309 helps to confine the fluid 315 since the fluid 315 is repelled by the hydrophobic layer 309.

In an embodiment, the pedestal 307 may optionally be surrounded by a plateau 308. The plateau 308 may be another extension up from the wafer 305. In an embodiment, the plateau 308 may have a top surface that is substantially coplanar with a top surface of the pedestal 307. In other embodiments, the top surface of the plateau 308 maybe above or below the top surface of the pedestal 307. As shown, the hydrophobic layer 309 maybe over sidewalls of the plateau 308. In other embodiments, the hydrophobic layer 309 may also be applied over a top surface of the plateau 308.

In an embodiment, stubs 330 may extend up from the plateau 308. The stubs 330 are the mechanical feature that allows for size differentiation during batch processing. Particularly, the stubs 330 are a mechanical feature that blocks certain dies from being brought into close enough proximity to the fluid 315 in order to initiate a bond. For example, stubs 330 prevent dies that are larger than the span between opposite stubs 330 from bonding with the pedestal 307.

In an embodiment, the stubs 330 may be formed from any suitable material for a mechanical stop, such as, but not limited to, metals (e.g., copper nickel, etc.), inorganic materials (e.g., silicon nitride, silicon oxide, etc.), and polymers (e.g., epoxy, silicone, etc.). In an embodiment, the stubs 330 may have dimensions in the X-Y plane (i.e., left to right in Figure 3A, and into and out of the page of Figure 3A) that is approximately 500µm or smaller, approximately 100µm or smaller, or between approximately 1µm and approximately 100µm. The height of the stubs 330 maybe sufficient to prevent bonding between a die and the pedestal 307. In an embodiment, the height of the stubs 330 in the Z-direction (i.e., up and down in Figure 3A) maybe approximately 100µm or smaller, approximately 50µm or smaller, or between approximately 1µm and approximately 40µm. In an embodiment, the stubs 330 may be fabricated with any suitable semiconductor processing method or additive manufacturing process. For example, semiconductor processing methods may include lithographic patterning, etching, plating and the like. For example, additive manufacturing processes may include inkjet printing and the like.

In the illustrated embodiment, the stubs 330 are provided on the plateau 308. However, it is to be appreciated that the stubs 330 may alternatively be provided in the space between an edge of the pedestal 307 and an edge of the plateau 308. In such instances, the stubs 330 maybe taller in order to overcome the height of the pedestal 307. In yet another embodiment (and as will be described in greater detail below), the stubs 330 may be provided over both the plateau 308 and between the pedestal 307 and the plateau 308.

Referring now to Figure 3B, a plan view illustration of the wafer 305 is shown, in accordance with an embodiment. In the illustrated embodiment, the fluid 315 is removed in order to show the hydrophilic layer 311 over the pedestal 307 (not visible in Figure 3B). As shown, a plurality of stubs 330 are provided around a perimeter of the pedestal 307 and the hydrophilic layer 311. Particularly, three stubs 330 are provided along each of the edges of the hydrophilic layer 311 and the pedestal 307. However, it is to be appreciated that any number of stubs 330 may be provided along each edge. For example, one or more stubs 330 may be provided adjacent to each of the edges of the hydrophilic layer 311 and the pedestal 307.

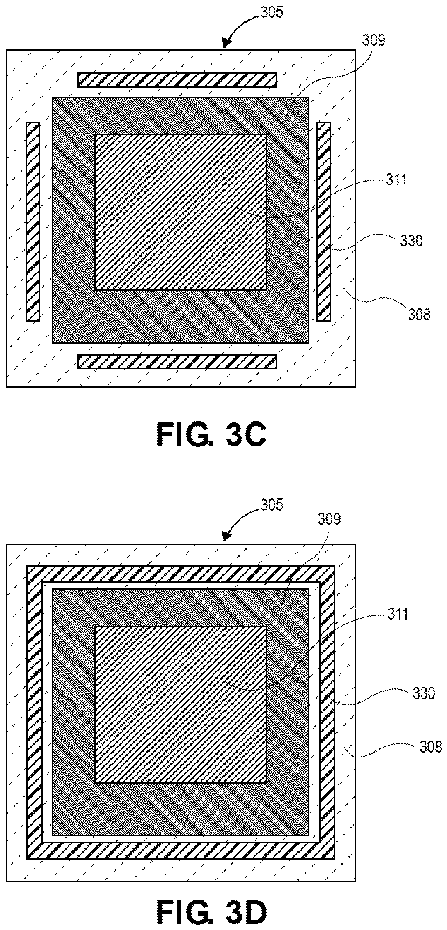

While shown as being discrete post like structures, it is to be appreciated that the stubs 330 may be elongated. An example of such an embodiment is shown in Figure 3C. As shown, each edge comprises an elongated stub 330 that extends along a portion of the edge of the hydrophilic layer 311 and the pedestal 307. In yet another embodiment, a single stub 330 may surround the entire perimeter of the hydrophilic layer 311 and the pedestal 307. Such an embodiment is shown in Figure 3D. Such a stub 330 maybe referred to as a stub ring or simply a ring since it forms a complete ring around the hydrophilic layer 311 and the pedestal 307.

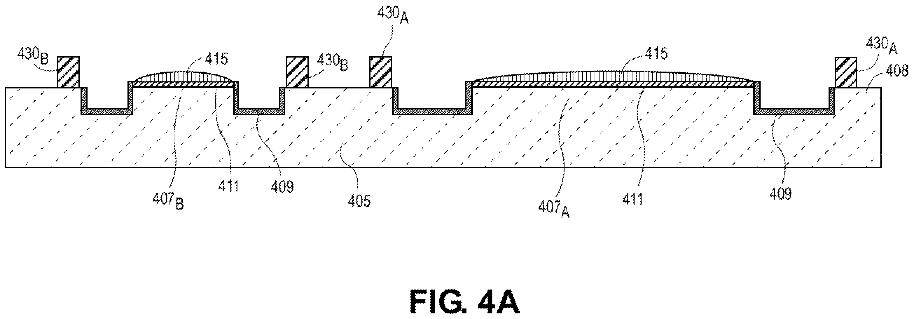

Referring now to Figures 4A-4C a series of cross-sectional illustrations depicting a process for attaching dies with different dimensions to a single wafer is shown, in accordance with an embodiment. As will be made apparent in the process flow, the order of operations starts with larger dies and progressively attaches smaller and smaller dies. In this way, the smaller dies cannot be misplaced onto pedestals that are designated for the larger dies.

Referring now to Figure 4A, a cross-sectional illustration of a wafer 405 is shown, in accordance with an embodiment. In an embodiment, the wafer 405 comprises a plurality of pedestals 407 that are separated by plateaus 408. For example, wafer 405 includes a first pedestal 407_{A} and a second pedestal 407_{B}. The first pedestal 407_{A} is larger than the second pedestal 407_{B}. As such, a larger die is attached to the first pedestal 407_{A} than is attached to the second pedestal 407_{B}.

In an embodiment, hydrophilic layers 411 are provided over the top surfaces of the first pedestal 407_{A} and the second pedestal 407_{B}. Remaining portions of the wafer 405 may be covered by a hydrophobic layer 409. The plateaus 408 are not covered by either a hydrophilic layer 411 or a hydrophobic layer 409. However, in other embodiments, the plateaus 408 may be covered by the hydrophobic layer 409.

In an embodiment, stubs 430 may be provided on the plateaus 408. First stubs 430_{A} are around the perimeter of the first pedestal 407_{A}, and second stubs 430_{B} are around the perimeter of the second pedestal 407_{B}. Each of the stubs 430 may be configured to allow dies of a certain dimension to successfully bond with the corresponding pedestal 407. For example, the first stubs 430_{A} maybe sized to receive a first die and the second stubs 430_{B} may be sized to receive a second die that is smaller than the first die.

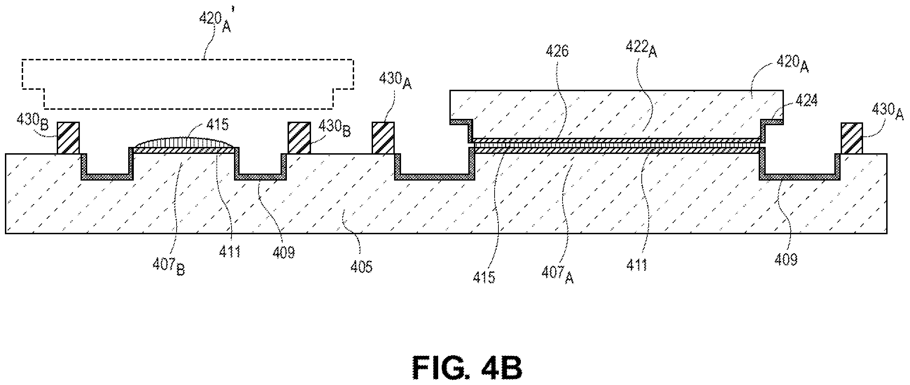

Referring now to Figure 4B, a cross-sectional illustration of the wafer 405 after a first die 420_{A} is attached to the first pedestal 407_{A} is shown, in accordance with an embodiment. The first die 420_{A} may comprise a pedestal 422_{A}. A hydrophilic layer 426 over a planar surface of the pedestal 422_{A} interfaces with the fluid 415 to secure the first die 420_{A} to the wafer 405. The first die 420_{A} may also comprise hydrophobic layers 424 to help confine the fluid 415 and aid in the alignment.

As shown in Figure 4B, the first die 420_{A} has a dimension (e.g., a width) that is sized to fit through the first stubs 430_{A}. In a particular embodiment, a width of the pedestal 422_{A} is sized to fit through the first stubs 430_{A}. That is, the upper portion of the first die 420_{A} (i.e., the portion of the first die 420_{A} from which the pedestal 422_{A} extends) may be wider than the opening between the first stubs 430_{A} in some embodiments. When the first stub 430_{A} is a ring, a width of the first die 420_{A} is smaller than an interior diameter of the ring. When the first stub 430_{A} is a plurality of post-like structures or elongated planes, the width of the first die 420_{A} is smaller than a distance between stubs 430_{A} on opposite sides of the first pedestal 407_{A}. Additionally, a dashed outline 420_{A}' of the first die 420_{A} is shown over the second pedestal 407_{B}. The dashed outline 420_{A}' illustrates that a width of the first die 420_{A} is greater than a distance between the second stubs 430_{B}. Accordingly, the first die 420_{A} can be moved across the second pedestal 407_{B} without risking bonding to the second pedestal 407_{B}, because the second stubs 430_{B} prevent the first die 420_{A} from getting physically close enough to the second pedestal 407_{B} to bond.

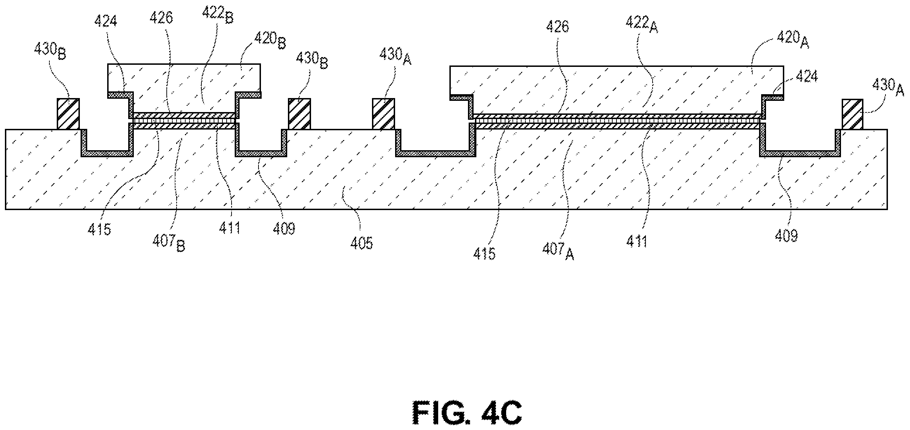

Referring now to Figure 4C, a cross-sectional illustration of the wafer 405 after a second die 420_{B} is attached to the second pedestal 407_{B} is shown, in accordance with an embodiment. In an embodiment, the second die 420_{B} may comprise a pedestal 422_{B} that is covered by a hydrophilic layer 426. A hydrophobic layer 424 may cover the other portions of the second die 420_{B}. As shown, a width of the second die 420_{B} is smaller than a distance between the second stubs 430_{B}. As such, the second die 420_{B} can move physically close enough to the second pedestal 407_{B} in order to make a bond. In a particular embodiment, a width of the pedestal 422_{B} is sized to fit through the second stubs 430_{B}. That is, the upper portion of the second die 420_{B} (i.e., the portion of the second die 420_{B} from which the pedestal 422_{B} extends) may be wider than the opening between the second stubs 430_{B} in some embodiments. Furthermore, it is appreciated that there is no issue with the second die 420_{B} bonding to first pedestals 407_{A}. This is because all first pedestals 407_{A} will already be occupied by first dies 420_{A}.

In an embodiment, the bonding process may continue by removing the fluid 415 between the hydrophilic layers 411 and 426. This may be done with an evaporation process. After the fluid 415 is removed, the pedestals 422 can be bonded to the pedestals 407 with a bonding process, such as a hybrid bonding process, as is known in the art. The use of the hydrophilic layers 411 and 426 allow for a high degree of alignment (e.g., submicron alignments). Additionally, attaching dies in a large to small order with the use of mechanical stubs allows for size differentiation to be implemented in a batch processing method.

In addition to size differentiation, embodiments may also allow for orientation differentiation. Orientation differentiation ensures that only dies that are properly oriented (rotationally) are attached to the wafer. Rotational orientation can be difficult on square dies since each 90 degree rotation (in plane) has the same footprint. In rectilinear dies, each 180 degree rotation (in plane) has the same footprint. As such, a mechanical feature can be provided using stubs in order to ensure proper rotational orientation.

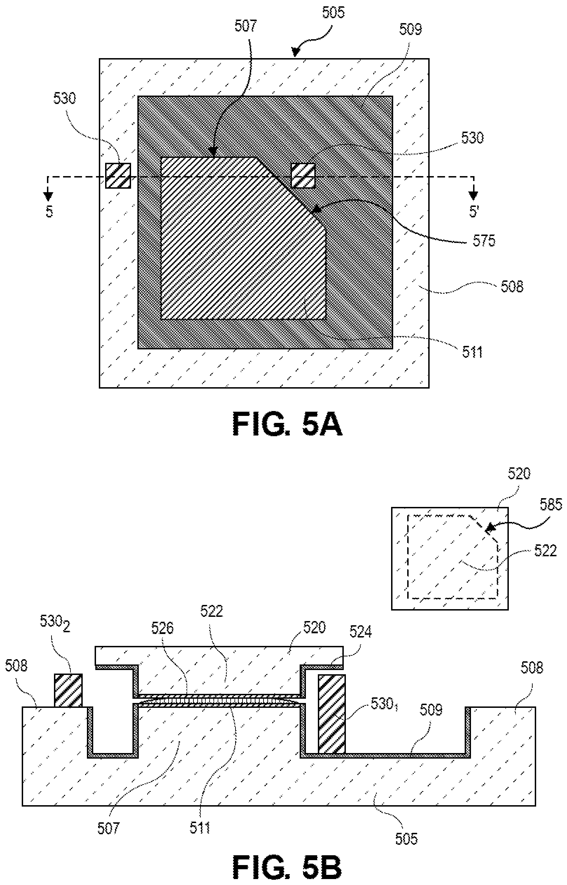

Referring now to Figure 5A, a plan view illustration of a portion of a wafer 505 is shown, in accordance with an embodiment. The wafer 505 may include a plateau 508 around a pedestal 507 that is below a hydrophilic layer 511. A hydrophobic layer 509 is between the pedestal and the plateau 508. In an embodiment, the pedestal 507 may comprise a chamfered surface 575. In an embodiment, a stub 530 is placed adjacent to the chamfered surface 575. This results in the distance between the two illustrated stubs 530 being smaller than a maximum width of the pedestal 507. The die that is placed onto the pedestal 507 will have a matching chamfer. Accordingly, the only way for the die to fit through the stubs 530 is to have a matching orientation of its chamfered surface with the chamfered surface 575 of the pedestal 507.

Referring now to Figure 5B, a cross-sectional illustration of the wafer 505 with an attached die 520 is shown, in accordance with an embodiment. As shown in the plan view illustration of the die 520, the orientation of the chamfered surface 585 of the die 520 is matched with the chamfered surface 575 shown in Figure 5A. As such, the die 520 fits between the stubs 530₁ and 530₂. In an embodiment, aside from the inclusion of the chamfered surface 585, the die 520 maybe substantially similar to other dies described herein. For example, the die 520 may comprise a pedestal 522 with a hydrophilic layer 526, and a hydrophobic layer 524 over other surfaces of the die 520.

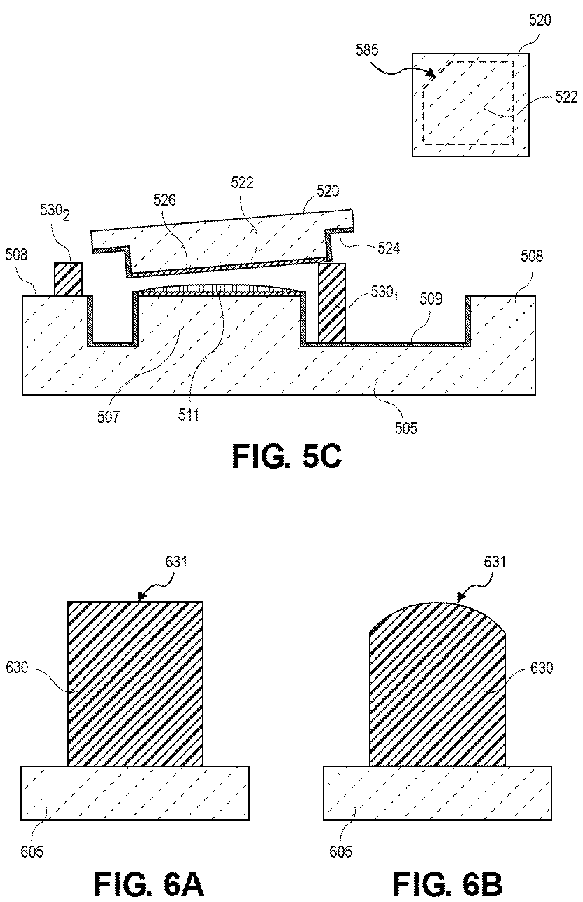

Referring now to Figure 5C, a cross-sectional illustration of the wafer 505 with a die 520 that is not able to attach to the pedestal 507 of the wafer 505 is shown, in accordance with an embodiment. As shown in the plan view illustration of the die 520, the orientation of the chamfered surface 585 of the die 520 is oriented differently than the orientation of the chamfered surface 575 shown in Figure 5A. As such, the width of the pedestal 522 is too large to fit on the pedestal 507. Accordingly, embodiments disclosed herein provide orientation differentiation as well.

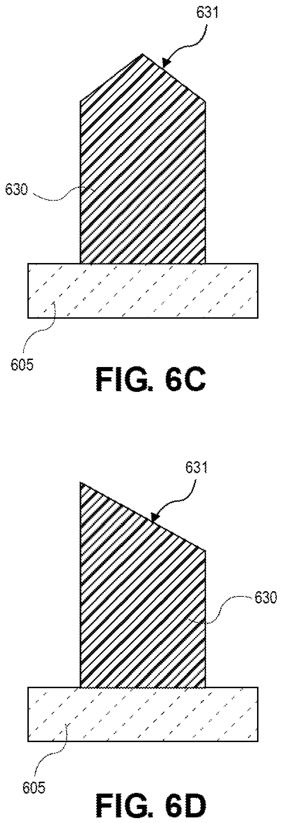

Referring now to Figures 6A-6D, cross-sectional illustrations of various stub 630 cross-sections are shown, in accordance with various embodiments. In Figure 6A, the stub 630 is shown with a substantially planar top surface 631 that is parallel to a surface of the wafer 605. In Figure 6B, the stub 630 has a top surface 631 that is domed. In Figure 6C, the top surface 631 of the stub 630 is pointed. In Figure 6D, the top surface 631 of the stub 630 is flat and oriented at a non-parallel angle with a surface of the wafer 605. In other embodiments, the top surface 631 may be v-grooved or u-grooved.

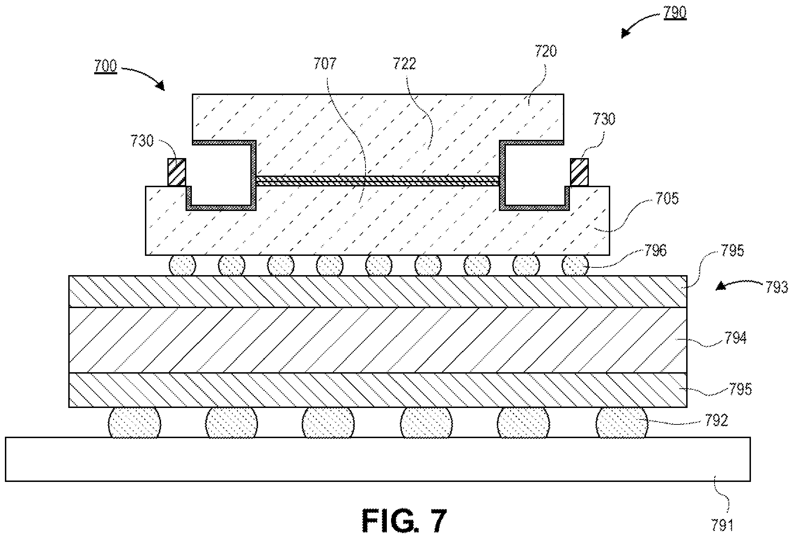

Referring now to Figure 7, a cross-sectional illustration of an electronic system 790 is shown, in accordance with an embodiment. In an embodiment, the electronic system 790 comprises a board 791, such as a printed circuit board (PCB) or the like. The board 791 may be coupled to a package substrate 793 by interconnects 792. The interconnects 792 may be solder balls, sockets, or the like. The package substrate 793 may comprise a core 794 and buildup layers 795. In other embodiments, the package substrate 793 may be coreless.

In an embodiment, a multi-die module 700 may be coupled to the package substrate 793 by first level interconnects (FLIs) 796, such as solder, copper bumps, or the like. The multi-die module 700 may include a first die 705. The first die 705 may comprise a pedestal 707 and stubs 730 adjacent to edges of the pedestal 705. The stubs 730 may be a remnant from an assembly operation used to ensure that the second die 720 is properly sized and/or oriented with respect to the first die 705. The second die 720 may comprise an additional pedestal 722 that is aligned with the pedestal 707.

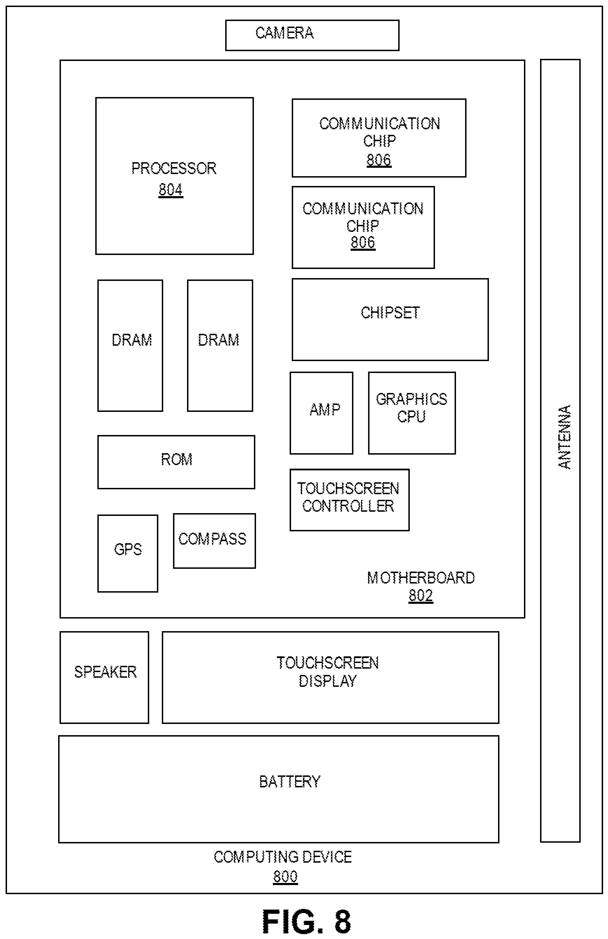

Figure 8 illustrates a computing device 800 in accordance with one implementation of the invention. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the invention, the integrated circuit die of the processor may be part of an electronic package that comprises a multi-chip module with a first die that comprises stubs for aligning a second die, in accordance with embodiments described herein. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the invention, the integrated circuit die of the communication chip may be part of an electronic package that comprises a multi-chip module with a first die that comprises stubs for aligning a second die, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: a multi-die module, comprising: a first die, wherein the first die comprises: a first pedestal; a plateau around the first pedestal; and a stub extending up from the plateau; and a second die, wherein the second die comprises: a second pedestal, wherein the second pedestal is attached to the first pedestal.

Example 2: the multi-die module of Example 1, wherein a hydrophilic layer is on the first pedestal and on the second pedestal.

Example 3: the multi-die module of Example 1 or Example 2, wherein a hydrophobic layer is on sidewalls of the first pedestal, on a surface of the first die between the first pedestal and the plateau, and on the plateau.

Example 4: the multi-die module of Examples 1-3, wherein the stub is a continuous ring that extends around the first pedestal.

Example 5: the multi-die module of Example 4, wherein an inner diameter of the continuous ring is larger than a width of the second pedestal.

Example 6: the multi-die module of Examples 1-3, wherein a plurality of stubs are provided on the plateau.

Example 7: the multi-die module of Examples 1-6, wherein the stub has a height that is approximately 50µm or less.

Example 8: the multi-die module of Examples 1-7, further comprising: a second stub on a surface of the first die between the first pedestal and the plateau, and wherein the second pedestal has a chamfered corner that is adjacent to the second stub.

Example 9: the multi-die module of Example 8, wherein a maximum width of the second pedestal is greater than a distance between the stub and the second stub.

Example 10: the multi-die module of Examples 1-9, wherein the stub has a top surface that is domed, flat, v-grooved, u-grooved, or pointed.

Example 11: a die, comprising: a semiconductor substrate; a pedestal extending up from the semiconductor substrate; and a stub adjacent to the pedestal, wherein a top surface of the stub is higher than a top surface of the pedestal.

Example 12: the die of Example 11, wherein the stub is a ring that surrounds a perimeter of the pedestal.

Example 13: the die of Example 11 or Example 12, further comprising a plateau around the pedestal, wherein the stub extends up from the plateau.

Example 14: the die of Examples 11-13, further comprising: a hydrophilic layer over the top surface of the pedestal.

Example 15: the die of Example 14, further comprising: a hydrophobic layer over sidewalls of the pedestal and over surfaces of the semiconductor substrate.

Example 16: the die of Examples 11-15, further comprising: a plurality of stubs, wherein the stubs surround a perimeter of the pedestal.

Example 17: the die of Examples 11-16, wherein the top surface of the stub is approximately 50µm or less above the top surface of the pedestal.

Example 18: the die of Examples 11-17, wherein the top surface of the stub is domed, flat, v-grooved, u-grooved, or pointed.

Example 19: a method of attaching dies to a wafer, comprising: attaching a first die to a first pedestal on the wafer, wherein the first pedestal is surrounded by one or more first stubs, and wherein the first pedestal has a first width; and attaching a second die to a second pedestal on the wafer, wherein the second pedestal is surrounded by one or more second stubs, and wherein the second pedestal has a second width that is smaller than the first width.

Example 20: the method of Example 19, wherein the first die is prevented from attaching to the second pedestal by the one or more second stubs.

Example 21: the method of Example 19 or Example 20, wherein the first die is attached to the first pedestal by hydrophilic bonding, and wherein the second die is attached to the second pedestal by hydrophilic bonding.

Example 22: the method of Examples 19-21, wherein the one or more first stubs comprise a first ring surrounding a perimeter of the first pedestal, and wherein the one or more second stubs comprise a second ring surrounding a perimeter of the second pedestal.

Example 23: an electronic system, comprising: a board; a package substrate coupled to the board; and a multi-die module coupled to the package substrate, wherein the multi-die module comprises: a first die, wherein the first die comprises: a first pedestal; a plateau around the first pedestal; and a stub extending up from the plateau; and a second die, wherein the second die comprises: a second pedestal, wherein the second pedestal is attached to the first pedestal.

Example 24: the electronic system of Example 23, wherein the stub is a ring surrounding a perimeter of the first pedestal.

Example 25: the electronic system of Example 24, wherein a width of the second pedestal is smaller than an inner diameter of the ring.

## Claims

1. A multi-die module, comprising:
a first die, wherein the first die comprises:
a first pedestal;
a plateau around the first pedestal; and
a stub extending up from the plateau; and
a second die, wherein the second die comprises:
a second pedestal, wherein the second pedestal is attached to the first pedestal.

2. The multi-die module of claim 1, wherein a hydrophilic layer is on the first pedestal and on the second pedestal.

3. The multi-die module of claim 1 or 2, wherein a hydrophobic layer is on sidewalls of the first pedestal, on a surface of the first die between the first pedestal and the plateau, and on the plateau.

4. The multi-die module of claim 1, 2 or 3, wherein the stub is a continuous ring that extends around the first pedestal.

5. The multi-die module of claim 4, wherein an inner diameter of the continuous ring is larger than a width of the second pedestal.

6. The multi-die module of claim 1, 2 or 3, wherein a plurality of stubs are provided on the plateau.

7. The multi-die module of claim 1, 2, 3, 4, 5 or 6, wherein the stub has a height that is approximately 50µm or less.

8. The multi-die module of claim 1, 2, 3, 4, 5, 6 or 7, further comprising:
a second stub on a surface of the first die between the first pedestal and the plateau, and wherein the second pedestal has a chamfered corner that is adjacent to the second stub.

9. The multi-die module of claim 8, wherein a maximum width of the second pedestal is greater than a distance between the stub and the second stub.

10. The multi-die module of claim 1, 2, 3, 4, 5, 6, 7, 8 or 9, wherein the stub has a top surface that is domed, flat, v-grooved, u-grooved, or pointed.

11. A method of attaching dies to a wafer, comprising:
attaching a first die to a first pedestal on the wafer, wherein the first pedestal is surrounded by one or more first stubs, and wherein the first pedestal has a first width; and
attaching a second die to a second pedestal on the wafer, wherein the second pedestal is surrounded by one or more second stubs, and wherein the second pedestal has a second width that is smaller than the first width.

12. The method of claim 11, wherein the first die is prevented from attaching to the second pedestal by the one or more second stubs.

13. The method of claim 11 or 12, wherein the first die is attached to the first pedestal by hydrophilic bonding, and wherein the second die is attached to the second pedestal by hydrophilic bonding.

14. The method of claim 11, 12 or 13, wherein the one or more first stubs comprise a first ring surrounding a perimeter of the first pedestal, and wherein the one or more second stubs comprise a second ring surrounding a perimeter of the second pedestal.
